# EUROPEAN PATENT SPECIFICATION

(11) **EP 0 568 353 B1**
(45) Date of publication and mention of the grant of the patent: **24.11.1999**
(21) Application number: 93303335.9
(22) Date of filing: 28.04.1993
(51) Int. Cl.: H03K 17/56, H03K 17/693

(54) **Control device for double gate semiconductor device**
Steuerschaltung für eine Halbleitervorrichtung mit zwei Steuereingängen
Circuit de commande pour un dispositif semi-conducteur avec deux grilles

(30) Priority: 01.05.1992 JP 11276392; 26.08.1992 JP 22679392
(43) Date of publication of application: 03.11.1993
(60) Divisional application: 98200352.7
(73) Proprietor: FUJI ELECTRIC CO., LTD., Kawasaki-shi Kanagawa 210 (JP)
(72) Inventor: Terasawa, Noriho, c/o Fuji Electric Co., Ltd., Kawasaki-shi, Kanagawa (JP); Miyasaka, Tadashi, c/o Fuji Electric Co., Ltd., Kawasaki-shi, Kanagawa (JP); Nishiura, Akira, c/o Fuji Electric Co., Ltd., Kawasaki-shi, Kanagawa (JP); Nishiura, Masaharu, c/o Fuji Electric Co., Ltd., Kawasaki-shi, Kanagawa (JP); Sakurai, Kenya, c/o Fuji Electric Co., Ltd., Kawasaki-shi, Kanagawa (JP); Otsuki, Masahito, c/o Fuji Electric Co., Ltd., Kawasaki-shi, Kanagawa (JP)
(74) Representative: Beresford, Keith Denis Lewis

(56) References cited:
- EP-A- 0 463 325
- PATENT ABSTRACTS OF JAPAN vol. 14, no. 38 (E-878)24 January 1990;& JP-A-1270352

## Description

The present invention relates to a structure of a control device for semiconductor power devices, selectable for thyristor operation or transistor operation as IGBT, specifically to a structure of a control device which makes semiconductor power device having two gate electrodes operable by a single signal.

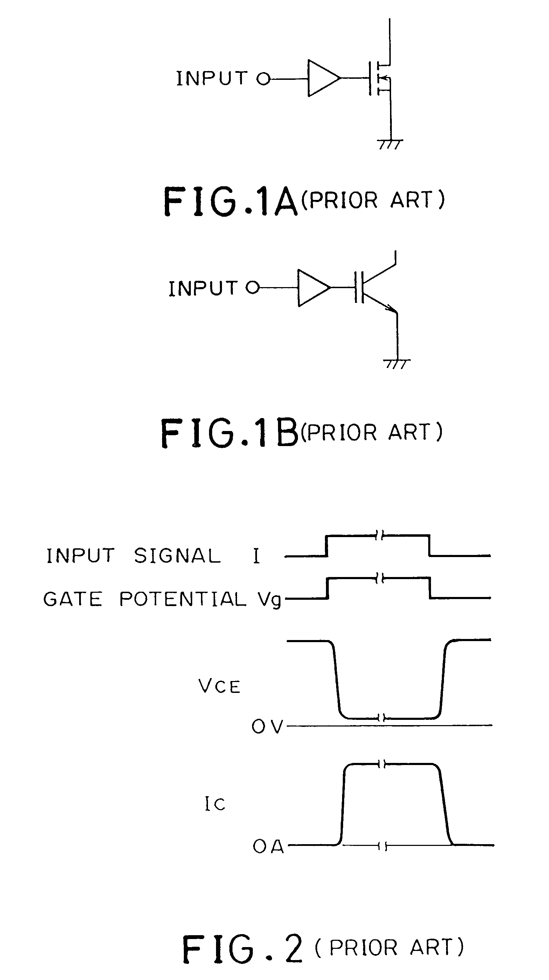

Fig. 1A and Fig. 1B show a structure of a connection circuit of conventional art MOSFET and IGBT. Such MOSFET and IGBT are an insulated gate type semiconductor device, which has a gate electrode formed through a gate oxide film on a semiconductor substrate provided with a drain, a source, an emitter, a collector, or the like, and controlled by a gate potential applied thereto. Fig. 2 shows a timing chart of such an insulated gate type semiconductor device. First, when an input signal I is at a low level, a potential Vg of the gate electrode applied with the input signal I also increases.

As a result, the MOSFET or IGBT becomes conductive. Therefore, an operating voltage Vce applied to between the emitter and collector or the like of the insulated gate type semiconductor device decreases, and a passing current Ic flowing between the emitter and collector or the like increases. Off course, there are some types of insulated gate semiconductor devices which make the reverse operation against the level of the input signal I.

As such an insulated gate type semiconductor device, a double gate semiconductor device having two gate electrodes as a device which has a low ON voltage to enable high-speed operation and reduce power loss and a short turn-on time is disclosed in detail in Japanese Patent Application No. 17575/1992 applied for by the same Applicant on February 3, 1992, published as JP-A-52 83 676. A brief structure of the double gate semiconductor device is shown in Fig. 3. The double gate semiconductor device comprises a p⁺ type substrate as a collector layer 2 provided on its backside with a collector electrode 1, and an n-type base layer 3 formed on the collector layer 2 by an epitaxial technique or the like. Corresponding European and United State Patent Applications based on the foregoing Japanese Patent Application had been filed on February 2nd, 1993, and these European and United State Patent Applications numbers are 93300748.6 and 014,454. The European application was published on August 8, 1993. A p⁻ type base layer 4 as a well-formed p⁺ type diffusion layer is formed on the surface of the n⁻ type base layer 3, and further n⁻ type emitter layers 5a and 5b are formed on the inside surface of the p- type base layer 4 by two n-type wells. In addition, two p⁺ type emitter layers 6a and 6b are formed on the inside surface of each of the n- type emitter layers 5a and 5b. These two p⁺ type emitter layers 6a and 6b and the n⁻ type emitter layers 5a and 5b are connected with an emitter electrode 7. From the p⁺ type emitter layer 6a, a first gate electrode 11 (hereinafter referred to as gate G1) constituting a first MOS 13 is provided over the surfaces of the n⁻ type emitter layer 5a or 5b, the p⁻ type base layer 4, and the n⁻ type base layer 3 through the gate oxide film 8. On the other hand, from the p⁺ type emitter layer 6b, a second gate electrode 12 (hereinafter referred to as gate G2) constituting a second MOS 14 is provided over the surfaces of the n⁻ type emitter layer 5a or 5b, and the p⁻ type base layer 4 through the gate oxide film 8.

In such a double gate semiconductor device, an npn type transistor Qnpn is formed of the n⁻ type emitter layer 5a, the p⁻ type base layer 4, and the n⁻ type base layer 3. Further, a pnp type transistor Qpnp is formed of the p⁻ type base layer 4, the n⁻ type base layer 3, and the p⁺ type collector layer 2. Therefore, when the MOS 13 comprising the gate G1 is turned on, the transistor Qpnp is turned on, and the device becomes conductive in an IGBT mode. Furthermore, when the MOS 14 comprising the gate G2 is turned on, the transistor Qnpn becomes an ON state. As a result, a thyristor 15 comprising the p⁺ type collector layer 2, the n⁻ type base layer 3, the p⁻ type base layer 4, and the n⁻ type emitter layer 5a becomes an ON state, a high density of carriers exist in the device, and the device has a low resistance. Thus, in the present device, a thyristor condition can be achieved by setting the gate G1 and the gate G2 to a high potential, thereby achieving a power device with a low ON voltage.

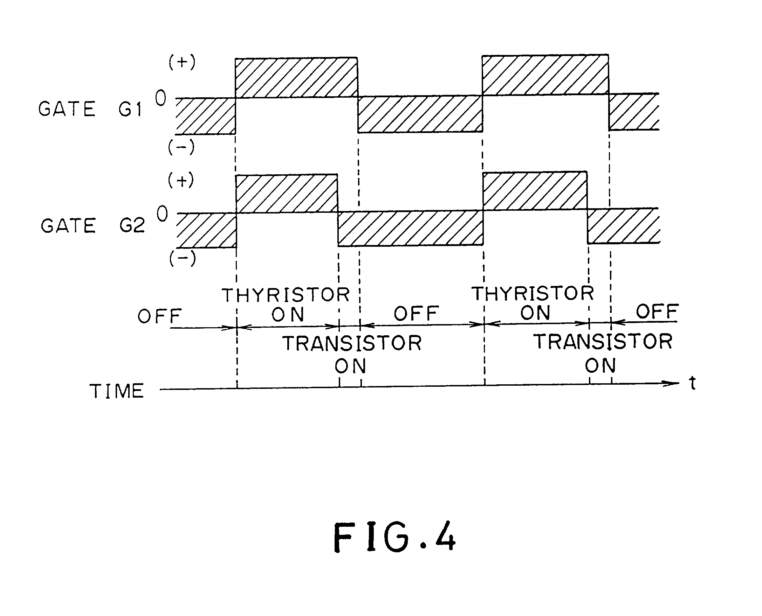

From the ON state, a gate 12 of the second MOS 14 comprising the gate G2 is set to a negative potential. As a result, the thyristor operation disappears since the transistor Qnpn is turned off, and a transistor state is achieved in which solely the transistor Qpnp comprising the p⁻ type base layer 4, the n⁻ type base layer 3, and the p⁺ type collector 2 operates. This condition is the same as the operating condition of IGBT, where the carrier density in the device is decreased. As a result, a carrier sweeping time can be reduced when the gate G1 is turned off, and the turn-off time can be reduced. Fig. 4 shows potentials of the gate G1 and the gate G2 for controlling the double gate semiconductor device. First, when the gates G1 and G2 are set to high potentials, the device becomes an ON state, and exhibits a low ON voltage under the thyristor condition. When a negative potential is applied to the gate G2, the device transfers to the transistor condition. Under this condition, when a negative potential is further applied to the gate G1, the device is turned off in a short turn-off time. The transition from the thyristor condition to the transistor condition can be completed in 0.5 microseconds or less. Thus, with the double gate semiconductor device, it becomes an ON state at a low voltage as used in MCT and the like, and also in high-frequency applications where the device becomes an OFF state in a short turn-off time as in IGBT, a power device with a reduced switching loss can be achieved.

A problem with the double gate semiconductor device when used in inverters or the like is that the control terminals have to be individually driven. That is, whereas a prior art power device has only a single control terminal connecting the gate electrode, and the power device can be controlled only by supplying a signal to drive the control terminal, in the double gate semiconductor device, two signals meeting the two control terminals connecting to the two gate electrodes have to be prepared. Furthermore, unless the two control signals are appropriately controlled, since the device does not positively transfer from the thyristor condition to the transistor condition, nor can be turned off, for inverters and the like, this tends to cause generation of an arm short-circuit, leading to a major accident.

Furthermore, since the double gate semiconductor device cannot be turned off unless it is transferred from the thyristor condition to the transistor condition, even when a trouble occurs at the initial state where the device becomes conductive, it is necessary to first transfer the device to the thyristor condition, and there is a possibility of occurrence of an unrestorable damage during the transition. Furthermore, since, even if a trouble occurs during operation, immediate shut-down is difficult, it is necessary to find a trouble during operation as early as possible and take a measure to transfer to the transistor condition.

In view of the above problems, it is a primary object of the present invention to provide a control device applied to a double gate semiconductor device having advantageous characteristics such as high speed and reduced power, which is possible to be handled as conventional power devices and protect the double gate semiconductor device from troubles such as an abnormal current and the like.

EP-A-0463325 discloses a driving device for controlling a semiconductor device having a transistor and a thyristor combined, the timing of signals for the driving device being controlled by a signal generator in which individual signal generating timings are controlled by changing the capacitance of a capacitor provided in a delay circuit.

EP-A-0429406 discloses a circuit for controlling a transistor having a single gate. The circuit performs a diagnosis to determine whether the drain of the transistor is short-circuited at a predetermined time, set by a delaying counter circuit, after the transistor is made conductive

The present invention provides a control device as set out in claim 1.

To prevent trouble due to an abnormality when turning on the double gate semiconductor device, the gate control means is arranged to apply a delayed turn-on signal to the second gate electrode. A turn-on signal application circuit unit may apply the turn-on signal to the second gate electrode according to the detecting result of the detecting means, and the turn-off signal application circuit unit may apply a turn-off signal to the first gate electrode according to the detecting means result of the detecting means.

The present invention protects the double gate semiconductor device in operation.

When the first gate control means is timer delay means for delaying the turn-off signal for a predetermined time and applying it to the first gate, it is desirable to connect the timer delay means in series with first and second time constant determination units, and it is effective to input a turn-off signal from the turn-off signal application circuit unit to the second time constant determination unit. The first time constant determination unit and the second time constant determination unit can be first and second resistor means constituting the timer delay means, or first and second capacitors.

It is also desirable to provide rectification means allowing current to pass only in a direction from the second gate electrode to the first gate electrode and, in this case, it is effective that the first gate electrode, the second gate electrode, and the rectification means are formed of polycrystalline silicon formed on the surface of the double gate semiconductor device. When the first gate electrode is of an n⁻ type and the second gate electrode is of a p⁻ type, the n⁻ type portion of the rectification means having a pn junction may be connected to the first gate electrode, and the p⁻ type portion may be connected to the second gate electrode. Also, it is effective to connect the n⁻ type portion of the rectification means to the first gate electrode by aluminum deposition wiring, and the p⁻ type portion to the second gate electrode by aluminum deposition wiring.

In the control device of the above arrangement, when a turn-off signal to the double gate semiconductor device is delayed by the first gate control means capable delaying a turn-off signal and applied to the first gate electrode, after the double gate semiconductor device is transferred to the transistor condition by a turn-off signal applied to the second gate electrode, the first gate electrode can be applied with a turn-off signal, and it is possible to positively turn off the double gate semiconductor device. Therefore, it is possible to control the double gate semiconductor device by a single turn-off signal, and it is sufficient that an external device using the double gate semiconductor device may have a single control signal as in the prior art. When timer delay means is used as the first gate control means, the transistor condition can be turned off after a predetermined time for the transition from the thyristor condition to the transistor condition. It is also possible to determine the transition from the thyristor condition to the transistor condition according to an operating voltage applied to the collector electrode using the operation determination circuit unit. Therefore, after the transition to the transistor condition is confirmed using the turn-off signal application circuit unit, the transition from the transistor condition to a turn-off condition can also be positively achieved by applying a turn-off signal to the first gate electrode.

When the second gate control means which is capable of delaying the turn-on signal is used, first a turn-on signal can be applied to the first gate electrode to turn on the double gate semiconductor device from the transistor condition. Therefore, when there is an abnormality during an ON state, a turn-off signal can be applied to the first gate electrode to immediately turn off the double gate semiconductor device. When the double gate semiconductor device normally operates in the transistor condition, a turn-on signal can be applied from the second gate control means to the second gate electrode to transfer the device to the thyristor condition. As such second gate control means, an overcurrent in the transistor condition may be detected by the detecting means, when it is an overcurrent, no turn-on signal is applied from the turn-on signal application circuit to the second gate electrode, but on the contrary, a turn-off signal is applied from the turn-off signal application circuit unit to the first gate electrode to set the double gate semiconductor device to an OFF state, thereby preventing the double gate semiconductor device from a trouble such as burning.

Furthermore, a passing current of the double gate semiconductor device is monitored by the detecting means and a turn-off signal can be outputted depending on the value of passing current to protect the double gate semiconductor device earlier than other protective circuits. The turn-off signal can be a single signal when the first gate control means is used and, as the detecting means it is possible to use a circuit for detecting the passing current, a circuit for determining from the operating current, or the like.

In the timer delay means of the first gate control means, the delay time of turn-off signal generation during occurrence of an abnormality is reduced by connecting the first and second time constant determination units in series and inputting a turn-off signal to the second time constant determination unit. Therefore, when an abnormality occurs, it is possible to reduce the time from the transistor condition to turning off to prevent the double gate semiconductor device from being damaged.

Furthermore, when the rectification means is provided, occurrence of an inhibited mode such that the potential of the second gate electrode is higher than the first gate electrode can be prevented in any cases. Therefore, the double gate semiconductor device can be prevented from being latched up uncontrollably.

The above and other objects, effects, features and advantages of the present invention will become more apparent from the following description of embodiments thereof taken in conjunction with the accompanying drawings.
Fig. 1A is a circuit diagram showing an example of control method for a prior art insulated gate type semiconductor device;
Fig. 1B is a circuit diagram showing another example of control method for a prior art insulated gate type semiconductor device;
Fig. 2 is a timing chart showing the operation of the semiconductor device by the control methods shown in Figs. 1A and 1B;
Fig. 3 is a schematic cross sectional illustration showing the structure of double gate semiconductor device;
Fig. 4 is a timing chart showing the operation of the double gate semiconductor device shown in Fig. 3;
Fig. 5 is a circuit diagram showing the structure of a control device according to a first comparative example;
Fig. 6 is a timing chart showing the operation of the control device shown in Fig. 5;
Fig. 7 is a circuit diagram showing the structure of a control device according to a second comparative example;
Fig. 8 is a circuit diagram snowing the structure of a control device according to a first embodiment of the present invention;
Fig. 9 is a timing chart showing the operation of the control device shown in Fig. 8 in a normal condition of the double gate semiconductor device;
Fig. 10 is a timing chart showing the operation of the control device shown in Fig. 8 in an abnormal condition of the double gate semiconductor device;
Fig. 11 is a circuit diagram showing a control device of a different structure according to the first embodiment of the present invention;
Fig. 12 is a circuit diagram showing a control device of a different structure according to the first embodiment of the present invention;
Fig. 13 is a circuit diagram showing the structure of a control device according to a second embodiment of the present invention;
Fig. 14 is a timing chart showing the operation of the control device shown in Fig. 13 in a normal condition of the double gate semiconductor device;
Fig. 15 is a timing chart showing the operation of the control device shown in Fig. 13 when an abnormality occurs at turning on the double gate semiconductor device;
Fig. 16 is a timing chart showing the operation of the control device shown in Fig. 13 when an abnormality occurs in the thyristor condition of the double gate semiconductor devices;
Fig. 17 is a circuit diagram showing the structure of a control device according to third embodiment of the present invention;
Fig. 18 is a perspective illustration showing a condition of a diode formed on the surface of a double gate MOS power device of the control device shown in Fig. 17;
Fig. 19 is a perspective illustration showing a condition of a diode formed as in Fig. 18 where the diode and a gate electrode is connected by aluminum deposition wiring; and
Fig. 20 is a circuit diagram showing another example of the structure of the control device according to the third embodiment of the present invention.

### First Comparative Example

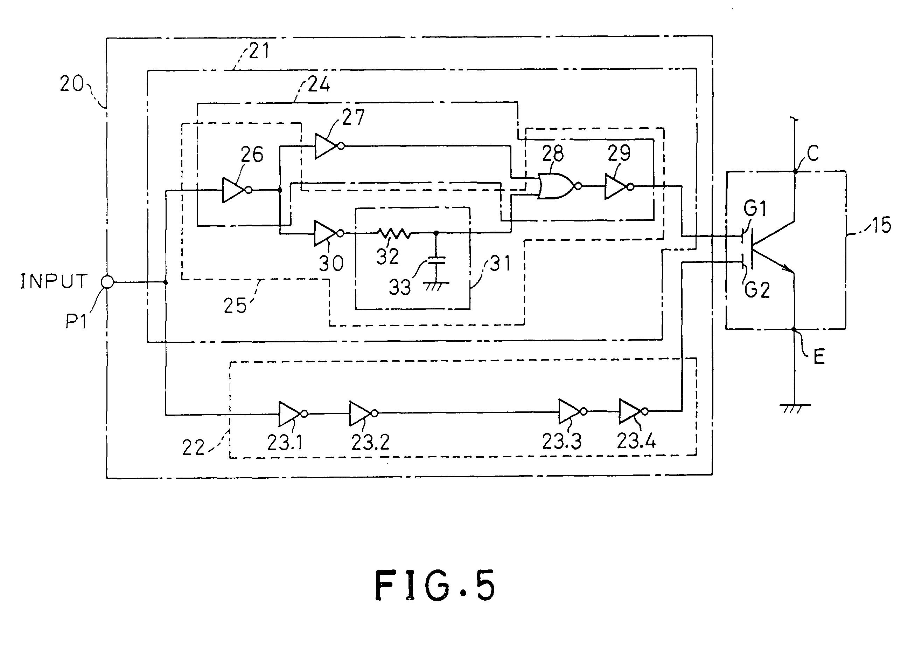

Fig. 5 shows the structure of a control device accordinq to a first comparative example.

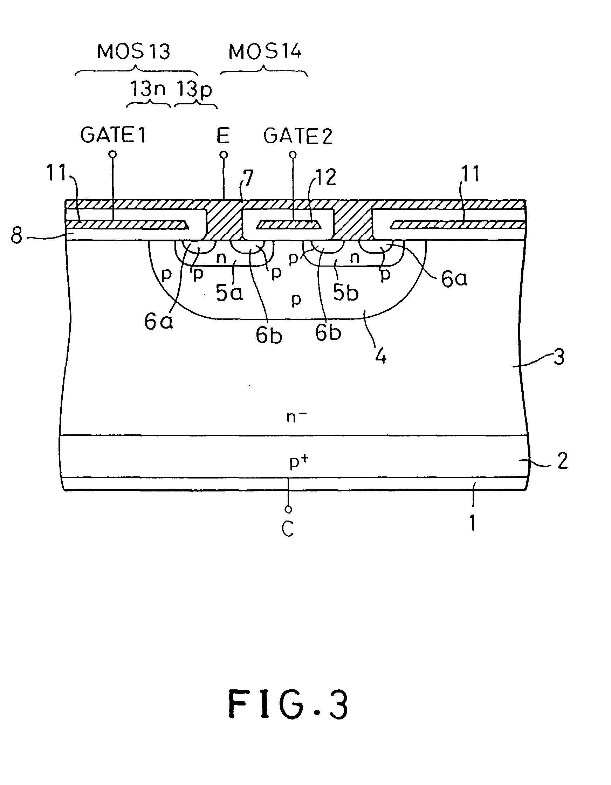

A control device 20 of the present example is a control device for driving a double gate semiconductor device 15 having a first gate G1 and a second gate G2, the structure and function of the double gate semiconductor device are as described previously with reference to Fig. 3 and Fig. 4, and description thereof is omitted here. The device 20 comprises a first gate control circuit 21 for applying a control signal inputted to an input terminal P1 to the gate G1, and a second gate control circuit 22 for applying a control signal inputted to the same input terminal P1 to the gate G2. First, in the second gate control circuit 22, four inverters 23.1 - 23.4 are connected in series, and an input signal is inverted, shaped, and then applied to the gate G2 of the double gate semiconductor device 15. Therefore, an intermediate potential time where the gate potential is unstable is reduced, thereby preventing a mis-operation.

On the other hand, the first gate control circuit 21 comprises two paths, that is, an ON path 24 and an OFF delay path 25. The ON path 24 comprises an inverter 26 used in combination with the OFF delay path 25, an inverter 27 connected in series with the inverter 26, a NOR gate 28 inputted with a signal from the inverter 27 and a signal from a delay circuit 31 of the OFF delay path 25, and an inverter 29 used in combination with the OFF delay path 25. The OFF delay path 25 comprises the inverter 26, an inverter 30 connected in series with the inverter 26, the delay circuit 31 including a resistor 32 and a capacitor 33, the NOR gate 28, and the inverter 29. Therefore, when a high-level turn-on signal is inputted to the input terminal P1, the the turn-on signal, after delaying by the inverters 26, 27, and 28, and the NOR gate 28, is applied to the gate G1. On the other hand, when a low-level turn-off signal is inputted, in addition to the above delay, the turn-off signal, after charging the delay circuit 31, is applied to the gate G1. Therefore, the first gate control circuit 21 is a control circuit in which only the turn-off signal is delayed by the time of the timer circuit 31 and applied to the gate G1. The inverters 26 and 30 also have a function for shaping the waveform of the input signal to suppress errors in delay time of the timer circuit 31.

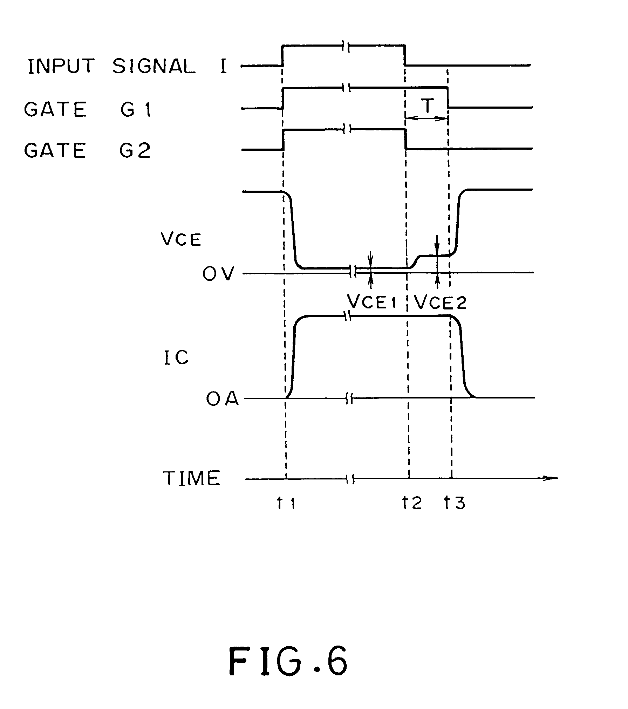

Fig. 6 shows the operation for controlling the double gate semiconductor device 15 using the control circuit 20. First, when an input signal I varies from a low level to a high level at a time t1, the signal is applied to the gate G1 and the gate G2. Therefore, the double gate semiconductor device 15 becomes a thyristor condition where it is conductive under a low-on resistance, and an operating voltage Vce between an emitter E and a collector C decreases to Vcel. On the other hand, a passing current Vc passing through the emitter E and the collector C increases. Then, when the input signal I varies from a high level to a low level at a time t2, the gate G2 is applied with the low-level signal, as is, and the gate G1 is continuously applied with a high-level signal by the delay circuit 31 of the first gate control circuit 21. Therefore, the double gate semiconductor device 15 transfers from the thyristor condition to a transistor condition which is the same condition as IGBT. At this moment, the turn-on resistor increases due to the transition from the thyristor condition to the transistor condition, and the operating voltage Vce increases from Vce1 to Vce2.

Then, since a low-level signal is applied to the gate G1 at a time t3 which is later by a delay time T than the time t2 due to the delay circuit 31, the double gate semiconductor device 15 is turned off. Therefore, the operating voltage Vce increases, and the passing current Ic decreases.

Thus, by providing the delay circuit 31 capable of delaying the signal for a predetermined time according to the present example in the first gate control circuit 21, it is possible to control the double gate semiconductor device 15 by the single input signal I. Furthermore, by adjusting the delay time T, it is possible to apply a turn-off signal to the gate G1 after the completion of the transition from the thyristor condition to the transistor condition, thereby positively turning off the double gate semiconductor device.

### Second Background Example

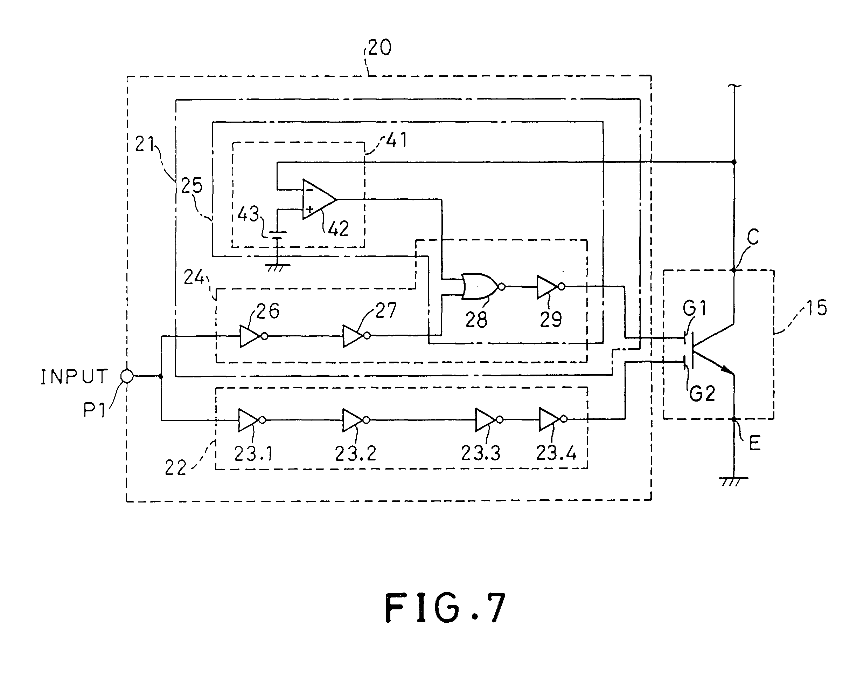

Fig. 7 shows the structure of the control device according toa second background example. The control device 20 in the present example , as in the first example , is a control device for driving the double gate semiconductor device 15 having the first gate G1 and the second gate G2, similar components are indicated by similar symbols and description thereof is omitted. The control device 20 of the present example, as in the first example , comprises the first gate control circuit 21 for applying a control signal inputted to the input terminal P1 to the gate G1, and the second gate control circuit 22 for applying a control signal inputted to the same input terminal P1 to the gate G2. A point to be noted in the control device 20 in the present example is that in the first gate control circuit 21, a comparator circuit 41 is provided in place of the delay circuit.

First, in the second gate control circuit 22, as in the first example, four inverters 23.1 - 23.4 are connected in series, and an input signal is inverted, shaped, and then applied to the gate G2 of the double gate semiconductor device 15. Similarly, the first gate control circuit 21 comprises the ON path 24 and the OFF delay path 25. The ON path 24 comprises inverters 26 and 27, the NOR gate 28 inputted with a signal from the inverter 27 and a signal from the comparator circuit 41 of the OFF delay path 25, and an inverter 29 commonly used with the turn-off delay circuit 25.

On the other hand, the OFF delay path 25 of the present device is provided with the comparator circuit 41 applied with the operating voltage Vce appearing as a collector voltage of the double gate semiconductor device 15, and its output is inputted to the NOR gate 28. The comparator circuit 41 comprises a comparator 42 applied with the operating voltage Vce to an inverted input, and a reference power supply 43 for generating a reference voltage applied to a non-inverted input of the comparator 42. Therefore, referring to the timing chart shown in Fig. 6, a turn-off signal is applied to the gate G2 at the time t2, when the double gate semiconductor device 15 transfers to the transistor condition, and the operating voltage Vce increases to Vce2. Since a reference voltage v0 inputted to the comparator 42 is set to a value lower than Vce2, when the operating voltage Vce exceeds the reference voltage V0, the output of the comparator 42 is inverted. As a result, signals from the ON path 24 and the OFF path 25 coincide in the NOR gate 28, and a turn-off signal is supplied from the first gate control circuit 21 to the gate G1. This stops operation of the double gate semiconductor device 15.

As described above, in the control device of the present example after the transition from the thyristor condition to the transistor condition is confirmed using the comparator circuit 41, a turn-off signal is applied to the gate G1. Therefore, as in the first example double gate semiconductor device 15 can be controlled by a single input signal, and the double gate semiconductor device 15 can be positively turned off.

### Embodiment 1

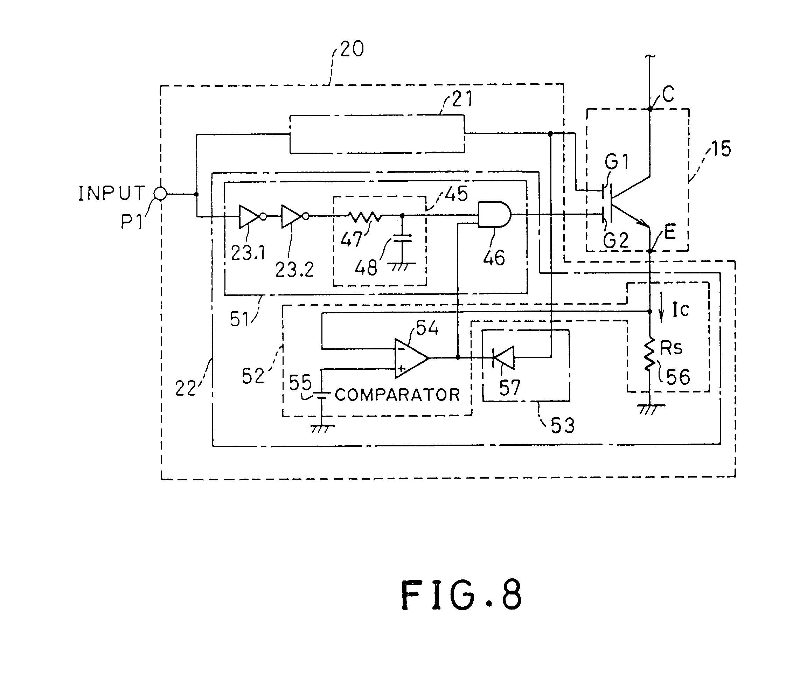

Fig. 8 shows the structure of the control device according to a first embodiment. The control device 20 of the present embodiment, as in the first example is a control device for driving the double gate semiconductor device 15 having the first gate G1 and the second gate G2, similar components are indicated by similar symbols and description thereof is omitted. The control device 20 of the present embodiment is provided with the first gate control circuit 21 of the same structure as in the example 1 or example 2. And, the control device 20 of the present embodiment is provided with the second gate control circuit 22 which is capable of delaying a turn-on signal to the gate G2.

That is, the second gate control circuit 22 of this device comprises a delay circuit 51 for delaying the input signal I inputted from the input terminal P1, a determination circuit 52 capable of detecting and determining the passing current Ic of the double gate semiconductor device 15, and a turn-off signal transmission circuit 53 capable of converting a turn-on signal applied to the gate G1 to a turn-off signal according to the determination result of the determination circuit 52. Furthermore, the determination result of the determination circuit 52 is reflected to the delay circuit 51 so that a turn-on signal from the delay circuit 51 is applied to the gate G2 according to the determination result of the determination circuit 52.

First, the delay circuit 51 for delaying the input signal I from the timing applied to the gate G1 comprises two inverters 23.1 and 23.2 connected in series, a delay circuit 45 for delaying signals from the inverters 23.1 and 23.2 for a predetermined time, and an AND gate 46 inputted with a signal from the delay circuit 45 and a signal from the determination circuit 52. Therefore, the turn-on signal inputted to the input terminal P1 is first applied to the gate G1 by the first gate control circuit 21, and delayed and applied to the gate G2. Therefore, by the control device 20 of the present embodiment, first the double gate semiconductor device 15 is started from the transistor condition.

The determination circuit 52 for inputting the determination result to the delay circuit 51 comprises a detection resistor 56 through which the passing current Ic of the double gate semiconductor device 15 passes, a comparator 54 supplied to its inverted input with a voltage drop in the detection resistor 56, and a reference power supply 55 for generating a reference voltage V1 supplied to a non-inverted input of the comparator 54. Therefore, when a turn-on signal is supplied to the gate G1 and the double gate semiconductor device 15 is in the transistor condition, the current Ic flows through the detection resistor 56, and a voltage drop proportional to the current Ic is compared with the reference voltage V1 by the comparator 54. Therefore, when a high passing current Ic exceeding a predetermined value flows under the transistor condition, a signal from the comparator 54 is inverted, and it can be determined whether or not the double gate semiconductor device 15 is started under an overcurrent condition. When it is an overcurrent condition, the turn-on signal delayed by the delay circuit 45 can be canceled by inputting the output from the comparator 54 of the determination circuit 52 to the AND gate 46 of the delay circuit 51.

The output of the determination circuit 52 is connected to the output of the first gate control circuit 21 through the turn-off signal transmission circuit 53. The turn-off signal transmission circuit 53 comprises a diode 57 of which a current flow from the output side of the first gate control circuit 21 to the determination circuit 52 side is the forward direction. When an overcurrent is detected by the determination circuit 52 and the output of the comparator 54 is inverted, the turn-on signal applied from the first gate control circuit 21 to the gate G1 is inverted, and the turn-off signal is supplied to the gate G1.

Therefore, when an overcurrent condition is detected by the determination circuit 52, the turn-on signal to the gate G2 is canceled by the delay circuit 51, whereas, a turn-off signal is supplied to the gate G1. Therefore, the double gate semiconductor device 15 is turned off.

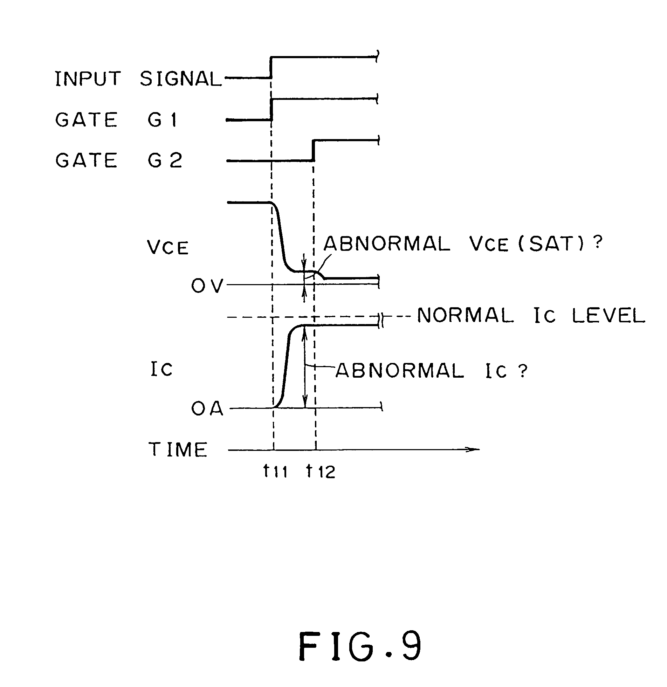

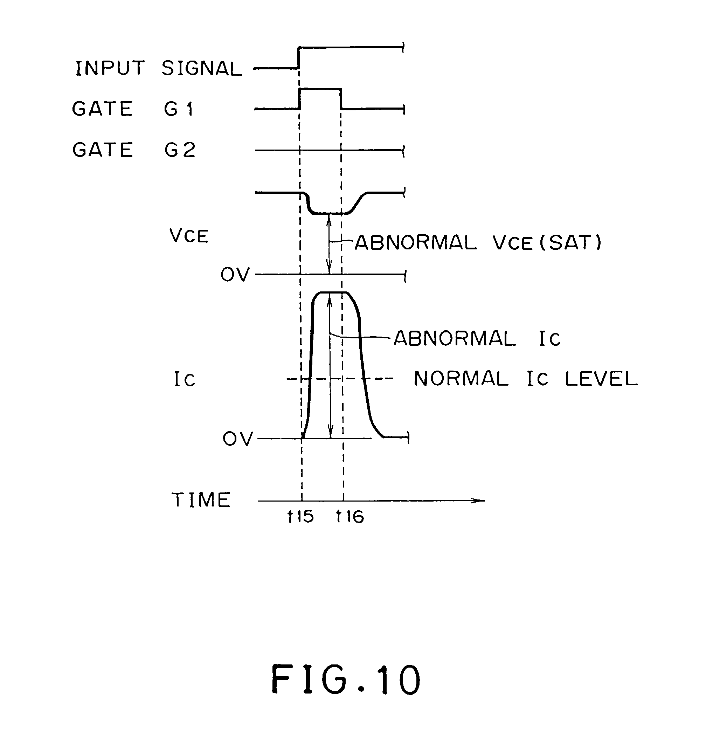

The operation of the control device 20 of the present embodiment will be described with reference to the timing charts shown in Fig. 9 and Fig. 10. Fig. 9 shows a normal start operation. First, when an input signal goes from a low level to a high level at a time t11, a high-level signal is supplied, as is, to the gate G1 by the first gate control circuit 21. On the other hand, a low-level signal is continued to be supplied to the gate G2 by the delay circuit 51 of the second gate control circuit 22. Therefore, the double gate semiconductor device 15 is not in the thyristor condition, but is conductive in the transistor condition. As a result, the conductive current Ic flows through the detection resistor 56, and a voltage drop in the detection resistor 56 is determined by the comparator 54. When the conductive current Ic is smaller than the normal Ic level, the output of the comparator 54 is not inverted, and at the time t2 after a predetermined time, a high-level turn-on signal is supplied from the delay circuit 51 to the gate G2. The double gate semiconductor device 15 transfers to the thyristor condition with a low-on resistance.

On the other hand, as shown in Fig. 10, when the device starts at a time 15 under the transistor condition, and when the conductive current Ic exceeds the normal Ic level, the output of the comparator 54 is inverted. Therefore, the turn-on signal is canceled in the second gate control circuit 22. Further, a turn-off signal is supplied by the turn-off signal transmission circuit 53 to the gate G1 at a time t16, and the double gate semiconductor device 15 is turned off. Thus, with the control device of the present embodiment, the double gate semiconductor device 15 is started in the transistor condition by the gate G1. Therefore, when an abnormality is detected by the determination circuit 52, the double gate semiconductor device 15 can be immediately turned off by supplying a turn-off signal to the gate G1. In the prior art control device, the double gate semiconductor device 15 is started in the thyristor condition, and even if an abnormality occurs, it is necessary to stop operation of the device after transition to the transistor condition, and the device may be unrestorably damaged during the transition. However, with the present control device, when an abnormality is detected, the device can be immediately stopped, thereby minimizing possible damages.

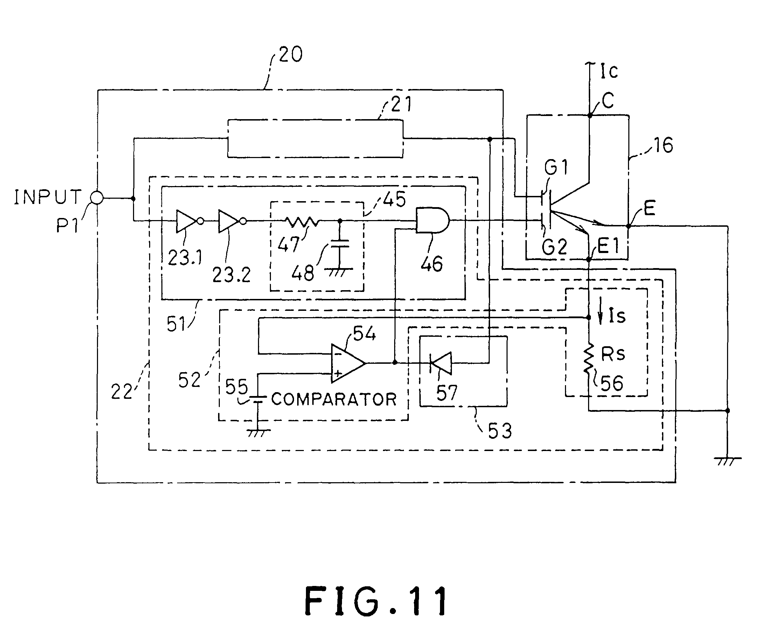

In the control device 20 shown in Fig. 8, the passing current Ic is determined using the detection resistor 56 connected to the emitter E side of the double gate semiconductor device 15. However, alternatively, it is of course possible to use a sense MOS 16 provided with a sense terminal E1 as shown in Fig. 11 to detect an overcurrent from a sense current Is flowing through the sense terminal E1. This is because the sensor current Is has a relation to the passing current Ic as Is = Ic/(sense ratio), and it is possible to determine the passing current Ic. Furthermore, since it is possible to suppress a detection current flowing through the detection resistor 56 to a low value, a power generated for the detection can be suppressed.

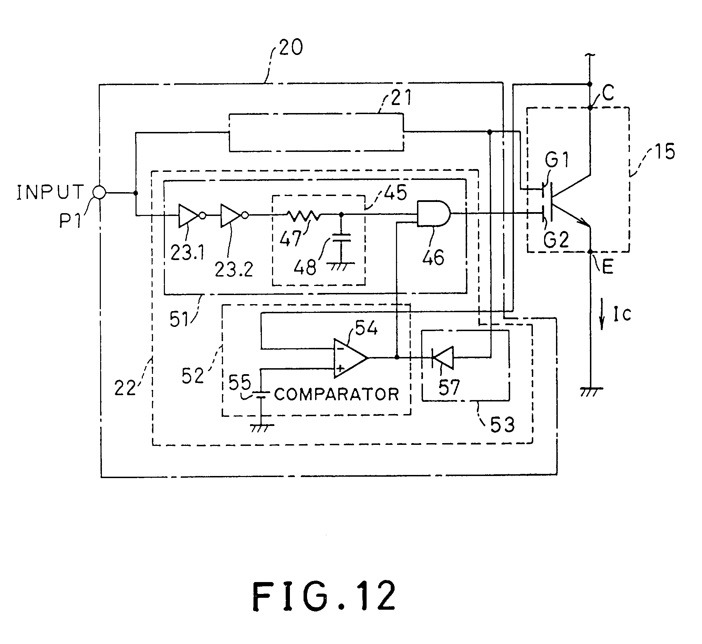

Furthermore, as shown in Fig. 12, since the operating voltage Vce increases when an abnormal Ic flows, an overcurrent condition can also be determined by supplying the operating voltage Vce to the inverted input of the comparator 54. Especially, in cases such as a low short-circuit, an arm short-circuit, and the like, Vce is almost the power supply rectification voltages, and it is sufficient to detect an overcurrent. Also with the present embodiment, a power required for the detection can be suppressed.

### Embodiment 2

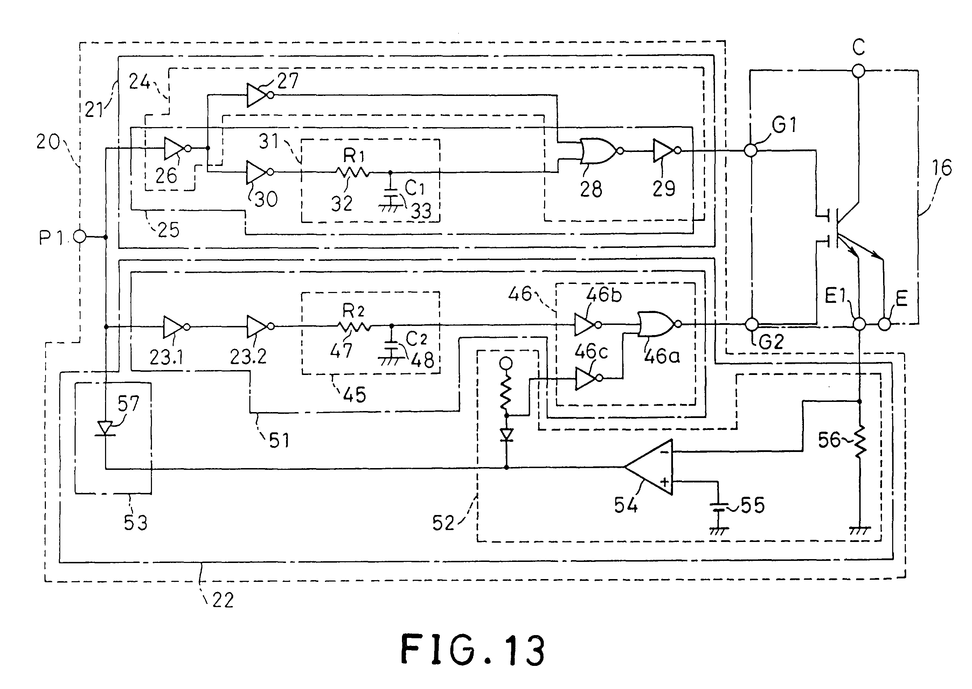

Fig. 13 shows the structure of the control device according to an embodiment 2 of the present invention. The control device 20 of the present embodiment, as in the above embodiment 1, is a control device for driving a double gate semiconductor device 16 with a sense MOS provided with the first gate G1, the second gate G2, and the sense terminal E1, nearly the same as the control device shown in Fig. 11. The control device 20 of the present embodiment is provided with the first gate control circuit 21 of the same structure as example 1 described with reference to Fig. 5. Furthermore, it has the second gate control circuit 22 capable of delaying a turn-on signal to the gate G2 as in the embodiment 1. Also similarly, the second gate control circuit 22 comprises the delay circuit 51 for delaying the input signal I inputted from the input terminal P1, the determination circuit 52 capable of detecting and determining the passing current Ic of the double gate semiconductor device 16, and the turn-off signal transmission circuit 53 for converting the turn-on signal applied to the gate G1 to the turn-off signal according to the determination result of the determination circuit 52. Therefore, similar components are indicated by similar symbols, and description thereof is omitted. A point to be noted in the present embodiment is that a turn-off signal from the turn-off signal transmission circuit 53 is not applied directly to the gate G1, but turns off an input signal from the first gate control circuit 21. Therefore, the operation of the double gate semiconductor device 16 with sense MOS can be assured even if a condition to transmit a turn-off signal is established momentarily due to a mis-operation or the like in the determination circuit 52. In the present embodiment, the AND gate 46 comprises two inverters 46b and 46c, and the NOR gate 46a, but the operation is the same as the above embodiment.

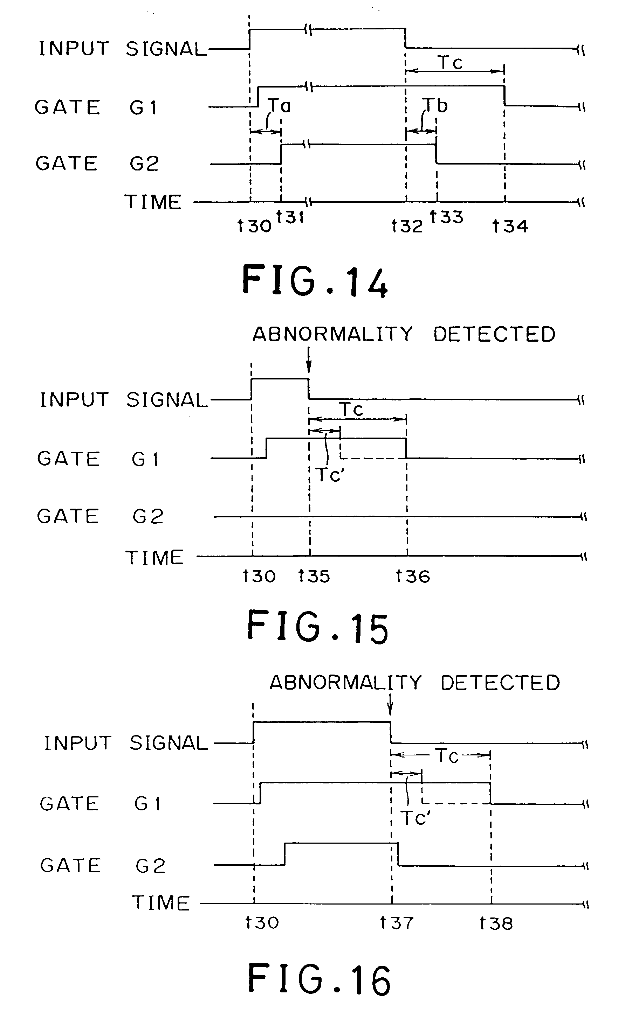

The operation of the control device 20 of the present embodiment will be described with reference to the timing charts shown in Fig. 14 to Fig. 16. The control device is provided with the delay circuit 31 in the first gate control circuit 21 to turn off the double gate semiconductor device 16 after the transition from the thyristor condition to the transistor condition. A delay time (off-delay time) Tdl of the delay circuit 31 depends upon the product of a resistor 32 and a capacitor 33 forming the delay circuit 31, that is, upon a time constant R1·C1. On the other hand, the second gate control circuit 22 is provided with the delay circuit 45 so that the device can transfer to the thyristor operation after the operation is confirmed in the transistor operation at turning on. A delay time (on-delay time) Td2 of the delay circuit 45 depends upon the product of a resistor 47 and a capacitor 48 forming the delay circuit 45, that is, upon a time constant R2·C2. Since, not only the turn-off signal but also the turn-on signal is applied to the double gate semiconductor device 16 past the second gate control circuit 22, the on-delay time Td2 is also the off-delay time of the second gate control circuit 22. Therefore, to turn off the double gate semiconductor device 16 after positive transition from the thyristor operation to the transistor operation using the first gate control circuit 21, it is necessary to satisfy R1·C1 > R2·C2. For this purpose, the delay circuits 31 and 45 of the control device 20 are designed so that the values of the resistors 32 and 47 and the capacitors 33 and 48 satisfy this relation.

Fig. 14 shows signals applied to the gate G1 and the gate G2 in the normal ON/OFF operation. When a turn-on signal is inputted at a time t30, after an operation delay time of the ON path 24 of the first gate control circuit 21, the signal at the gate G1 goes to a high level, and the double gate semiconductor device 16 goes to the transistor condition. And, at a time t31 after a turn-on delay time Ta of the second gate control circuit 22, the device transfers to the thyristor operation. On the other hand, when a turn-off signal is inputted at a time t32, the device transfers to the transistor operation at a time t33 after a turn-off delay time Tb of the second gate control circuit 22, and the double gate semiconductor device 16 is turned off at a time t34 after a turn-off delay time Tc of the first gate control circuit 21 from the time t32. The above-described turn-on or turn-off delay time Td2 is the times Ta and Tb, and the turn-off delay time Tdl is the time Tc. Therefore, since the time Tc is longer than the time Tb if the relation R1·C1 > R2·C2 is satisfied, after necessary transition to the transistor operation, the gate G1 is turned off, and the double gate semiconductor device 16 can be turned off.

Fig. 15 shows the operation when an abnormality is detected during the transistor operation at turning on. When a turn-on signal is inputted at the time t30, after an operation delay time as in Fig. 14, a high-level signal is applied to the gate G1, and the double gate semiconductor device is turned on in the transistor condition. When an abnormality is detected at a time t35 before the turn-on signal is applied to the gate G2, the device is turned off at a time t36 after the turn-off delay time Tc. Fig. 16 shows a case where an abnormality is detected during the thyristor operation of the double gate semiconductor device 16. The turn-on signal is inputted at the time t30, the gate G1 and the gate G2 go to a high level, when an abnormality is detected at a time t37 after the transition to the thyristor condition, the gate G2 goes to a low level after an operation delay of the determination circuit 52 including an abnormality detection comparator and the like, and the device goes to the transistor condition. And, also the gate G1 goes to a low level at a time t38 after the turn-off delay time Tc from the time t37, and the double gate semiconductor device 16 is turned off.

As described above, since the control device of the present embodiment goes off necessarily after the transition to the transistor condition even in an abnormal operation, it is possible to positively turn off the double gate semiconductor device. Furthermore, since the turning off is achieved under the condition where the gate G1 is at a high level and the gate G2 is at a low level, there is no danger of the generation of latching up.

### Embodiment 3.

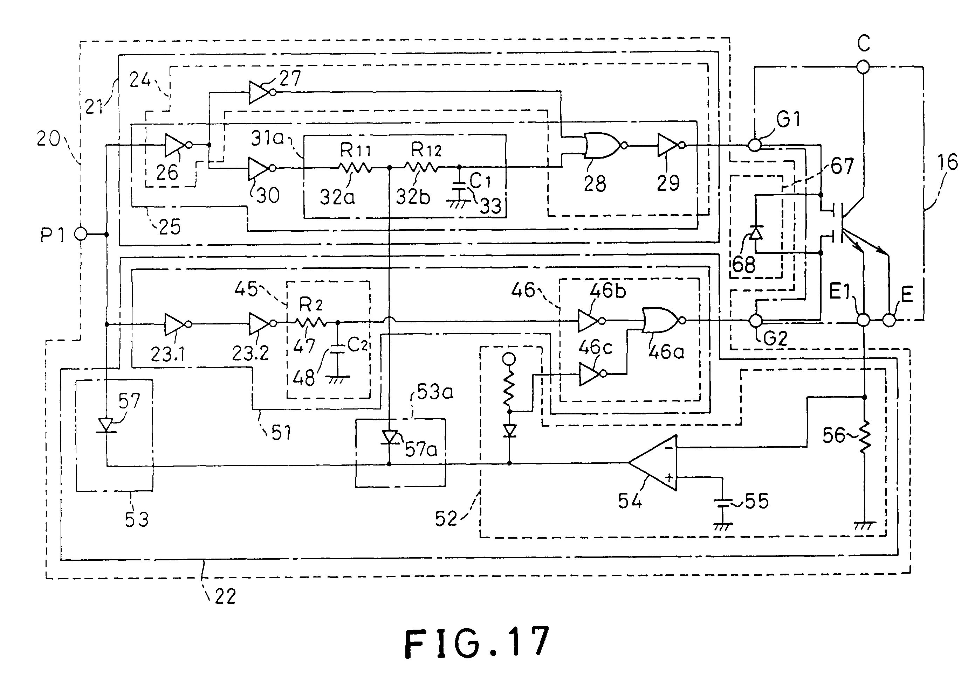

Fig. 17 shows the structure of the control device according to an embodiment 3 of the present invention. The control device 20 of the present embodiment, as in the embodiment 2, is a control device for driving the double gate semiconductor device 16 with a sense MOS provided with the first gate G1, the second gate G2, and the sense terminal E1, and is provided with the first gate control circuit 21 and the second gate control circuit 22. Therefore, similar components are indicated by similar symbols, and description thereof is omitted. A point to be noted in the present embodiment is that in the first gate control circuit 21, a delay circuit 31a is used as a circuit for setting the turn-off delay time, and the delay circuit 31a comprises two resistors 32a and 32b connected in series, and the capacitor 33. Also, the second gate control circuit 22 is provided with a turn-off signal transmission circuit 53a as a turn-off signal transmission circuit for abnormal condition use for supplying a turn-off signal to the delay circuit 31a, in addition to the turn-off signal transmission circuit 53 for supplying a turn-off signal to the input of the first gate control circuit 21. The turn-off signal transmission circuit 53a for abnormality use, as the turn-off signal transmission circuit 53, comprises a diode 57a, and the anode side of the diode 57a is connected to the upstream of the resistor 32b forming the delay circuit 31a, that is, the connection point of the resistors 32a and 32b.

Furthermore, a rectification circuit 67 for connecting the gate G1 and the gate G2 of the double gate semiconductor device 16 is used, and the rectification circuit 67 also comprises a diode 68 with the anode side being the gate G2 side.

The control device 20 of the present embodiment is a control device intended to reduce the turn-off delay time Tc of the control device shown in the embodiment 2. Specifically, in the control device of the embodiment 2 described with reference to Fig. 13, the turn-off delay time Tc for applying a low-level signal to the gate G1 is set to a sufficiently large value compared to the time Tb or Td2 for applying a low-level signal to the gate G1, whereby the transition from the thyristor condition to the transistor condition is positively achieved, and then the double gate semiconductor device is turned off. Therefore, it is a device that can assure the positive ON/OFF driving. On the other hand, even when an abnormality is detected, the device can be turned off only after the turn-off delay time Tc, which may be long for the double gate semiconductor device to be driven.

In this case, if the cause of the abnormality is an overcurrent generated due to an arm short-circuit during bridging operation, the double gate semiconductor device 16 evolves heat during the turn-off delay time Tc and increases in temperature, which may exceed the heat resistance limit leading to a breakdown.

Thus, in the control device 20 of the present embodiment, to allow a reduction in the turn-off delay time in an abnormal condition, the delay circuit 31a capable of varying the time constant which determines the delay time is used. In the delay circuit 31a of the present device, the time constant in a normal condition, that is, the time constant when a turn-off signal is inputted from the input terminal P1 is (R11 + R12)·C1. Therefore, the delay time Tc is determined by (R11 + R12)·C1.

On the other hand, in an abnormal condition where an overcurrent flows, the abnormality is detected in the determination circuit 52, and the output of the comparator 54 goes to a low potential. And, a low-potential turn-off signal is supplied by the turn-off signal transmission circuits 53 and 53a to the input of the first gate control circuit 21 and the upstream of the resistor 32b of the delay circuit 31a. Therefore, in the delay circuit 31a, the capacitor 33 is discharged only through the resistor 32b. Therefore, after a delay time Tc' determined by the time constant R12·C1, a turn-off signal is supplied to the NOR gate 28. Thus, in the present control device, the delay time in an abnormal condition can be reduced to R12/(R11 + R12), and temperature increase in the abnormal condition is suppressed to prevent the double gate semiconductor device 16 from breakdown. In the normal condition, a delay time Tc is applied which has a sufficient allowance for the transition from the thyristor operation to the transistor operation.

Furthermore, in the control device 20 of the present embodiment, the rectification circuit 67 to connect the gate G1 and the gate G2 is provided. As described in Fig. 14 to Fig. 16, it is necessary that the gate G1 goes to a high potential prior to the gate G2, and the gate G2 goes to a low potential prior to the gate G1. On the contrary, if the gate G2 goes to a higher potential than the gate G1, the double gate semiconductor device 16 will be in a latch-up condition to become uncontrollable. Therefore, the mode where the gate G2 is at a high potential and the gate G1 is at a low potential is an inhibited mode. However, it is considered that the gate G2 may go to a high potential by chance due to generation of a spark voltage or the like. Furthermore, until the double gate semiconductor device 16 is combined with the control device, or if any one of the gate G1 and the gate G2 is in an open condition even after being combined, such an inhibited mode may be achieved due to static charges or the like. Therefore, it is desirable that the inhibited mode will never be generated, and the control device of the present embodiment uses the rectification circuit 60 to prevent generation of the inhibited mode.

The rectification circuit 67 used in the control device 20 of the present embodiment comprises a diode 68. Even when a condition occurs where the potential of the gate G2 is higher than the potential of the gate G1 due to an external disturbance, clamping is established by a forward voltage of the diode 68, and generation of the above inhibited mode is prevented. Since the latch-up condition is not generated unless the potential of the gate G2 is to the extent, for example at least 3V, that the gate can sufficiently operate as a gate, it is sufficient to use the diode 68 having a forward voltage falling in this range. As the rectification circuit 67, it is possible to use an element of a totem pole type, or an open collector type by a pull-up resistor. Although being not shown, when the gate G1 or the gate G2 is connected through a gate resistor to prevent oscillation, the rectification circuit 67 may be disposed at the upstream of the gate resistor or, of course, at the downstream.

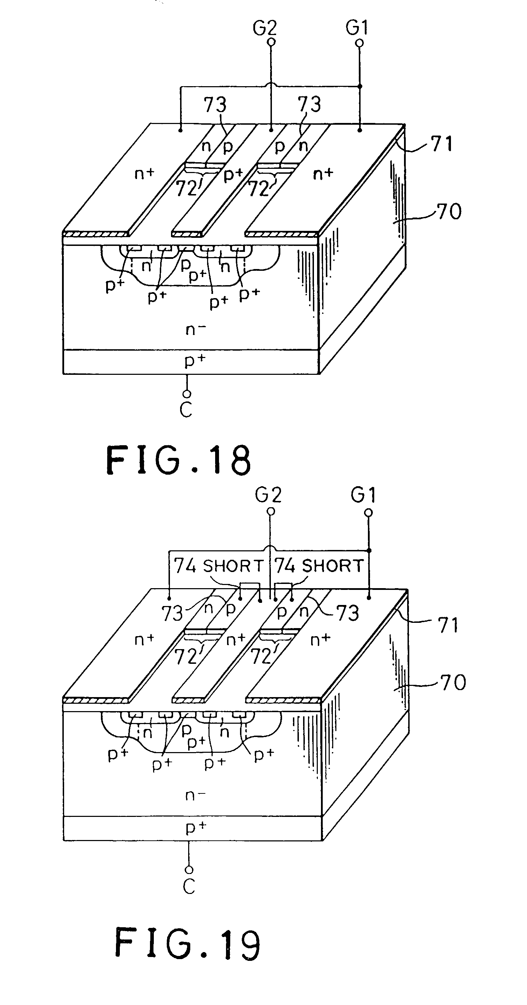

Fig. 18 shows an example in which the diode 68 is formed at the double gate semiconductor device side. The double gate semiconductor device shown in Fig. 18 is a double gate MOS power device 70, and polysilicon-based gate electrodes G1 and G2 are formed on a surface 71 of the device. All components are shown except the emitter electrode. The gate electrode G1 is adjusted to an n⁺ type by introducing a dopant such as phosphorus, and the gate electrode G2 is adjusted to a p⁺ type by introducing a dopant such as boron. A polysilicon layer 72 is formed on an area between the gate electrodes G1 and G2 except for an area of the emitter electrode (not shown), and a pn junction 73 is formed by introducing a dopant. Therefore, the diode 68 can be formed by the polysilicon layer 72, and it is possible to provide the rectification circuit 67. The individual gate electrodes and the emitter electrode (not shown) are insulated by silicon oxide films. It is of course possible to form a pn junction by directly connecting the high-concentration polysilicon layers forming the gate electrodes G1 and G2, but since the diode formed tends to have a low dielectric resistance and to be difficult to maintain reliability, in the present control device, a pn junction is separately formed using the polysilicon layer 72.

Fig. 19 shows an example in which a diode is formed on the surface 71 of the double gate MOS power device 70 as in Fig. 18. In the double gate MOS power device 70 shown in Fig. 21, both the gate electrodes G1 and G2 are formed of the n⁺ type, and it is superior to the double gate MOS power device shown in Fig. 18 in view of a reduction of the polysilicon resistance. However, it cannot be connected directly to the diode 61 formed between the gate electrodes G1 and G2 also using the polysilicon layer 72. Then, in the double gate MOS power device, a window is formed in an insulating layer (not shown) on the polysilicon layer, and the n⁺ type gate electrode G2 and a p⁻ type portion of the diode 68 are connected with an aluminum deposition wiring 74.

As shown above, the control device 20 of the present embodiment reduces the turn-off delay time in an abnormal condition to prevent the double gate semiconductor device from being damaged, generation of an inhibited mode is suppressed in all cases by introducing the rectification circuit, thereby achieving the safe and positive driving of the double gate semiconductor device.

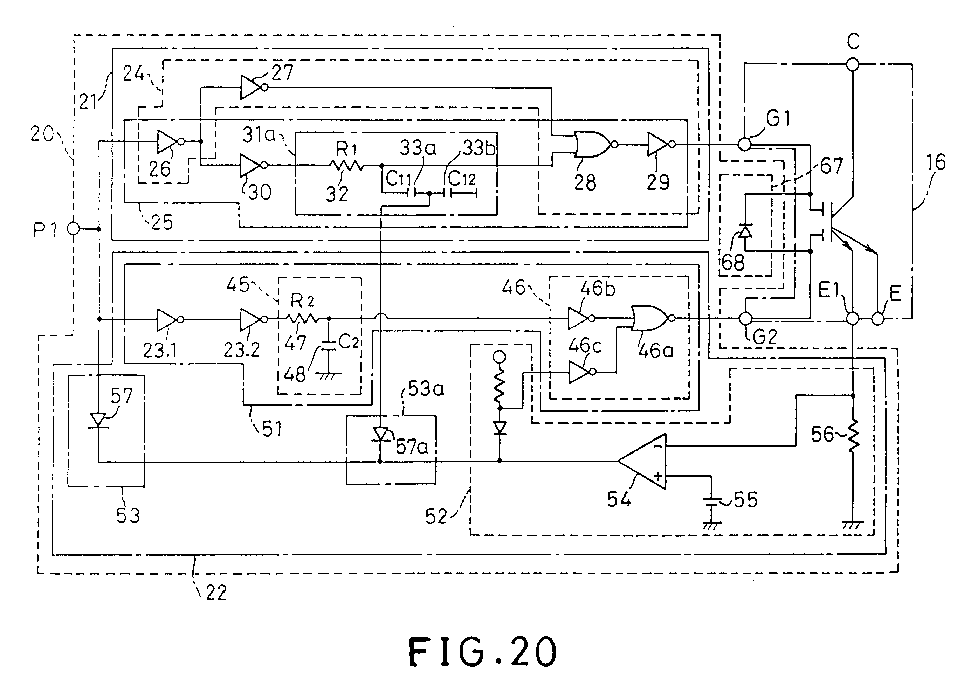

The present embodiment is described for an example where a resistor for determining the time constant of the delay circuit 31a is divided. Alternatively, however, as shown in Fig. 20, it is also possible to divide the capacitance and vary the time constant by using two capacitors 33a and 33b connected in series.

The embodiments 2 and 3 are described for the double gate semiconductor device having a sense MOS, however, it is of course possible to determine a main current flowing between the collector - emitter of the double gate semiconductor device.

As described above, in the control device for the double gate semiconductor device according to the present invention, first a turn-off signal to the double gate semiconductor device is delayed by the first gate control means capable of delaying a turn-off signal and applied to the first gate electrode, thereby stopping and controlling the double gate semiconductor device by a single control signal. Furthermore, using the second gate control means capable of delaying a turn-on signal, it is possible to immediately turn off the double gate semiconductor device even when an abnormality occurs at turning on, thereby preventing generation of unrestorable damages. Furthermore, when the passing current of the double gate semiconductor device is monitored by the passing current determination means and a turn-off signal is outputted according to the value of the passing current, the double gate semiconductor device can be protected earlier than other protective circuits.

Thus, the control device according to the present invention makes it possible to incorporate the advantageous double gate semiconductor device that can be turned on with a low turn-on resistance as with MCT and turned off in a short time as with IGBT in power converter apparatus and the like as prior art IGBT. And, it is a control device that can prevent the double gate semiconductor device from being damaged. Therefore, with the present control device, it is possible to widely apply double gate semiconductor devices which are power devices with reduced switching loss also in high-frequency applications.

By forming the timer delay means of the first gate control means using the first and second time constant determination units, it is possible to vary the turn-off delay time in abnormal and normal operation conditions. Therefore, in the abnormal operation condition, the turn-off delay time can be reduced to prevent the double gate semiconductor device from exceeding the heat resistance limit and leading to breakdown, thereby achieving a reliable control device.

Furthermore, by providing the rectification means, the generation of an inhibited mode where the potential of the second gate electrode is higher than the first gate electrode can be prevented in all cases, thereby preventing an uncontrollable malfunction and improving the reliability. In particular, using the polysilicon-based diode, rectification means can be provided in the double gate semiconductor device itself. This prevents the generation of dangers such as latch-up due to unforeseeable causes such as static charges even when the double gate semiconductor device is handled alone, and the control device can be formed compact.

The present invention has been described in detail with respect to preferred embodiments, and it will now be apparent from the foregoing to those skilled in the art that changes and modifications may be made without departing from the invention in its broader aspects, and it is the intention, therefore, in the appended claims to cover all such changes and modifications as fall within the true scope of the invention.

## Claims

1. A control device (20) for controlling a double gate semiconductor device (15;16) having a first gate electrode (G1) for controlling the ON/OFF transition of a transistor operation, and a second gate electrode (G2) for controlling the transition from a thyristor operation to a transistor operation, wherein the double gate semiconductor device (15,16) is transitted to a thyristor operation when a high voltage is applied to the first gate electrode (G1) and the second gate electrode (G2), and the double gate semiconductor device (15;16) is transitted to a transistor operation when a high voltage is applied only to the first gate electrode (G1), characterised by comprising:
first gate control means (21) having timer delay means (31) for delaying a turn-off signal to the first gate electrode (G1);
second gate control means (51) having timer delay means (45) for delaying both turn-on signals and turn-off signals to the second gate electrode (G2); and
detecting means (52) for detecting a passing current flowing from the collector electrode to the emitter electrode of said double gate semiconductor device (15;16), determining the detected current, and turning off the output signals of the first gate control means (21) and the second gate control means (51) when an abnormal current is detected.

2. A control device (20) according to claim 1, wherein said detecting means (52) is arranged to suppress a delayed turn-on signal to said second gate electrode (G2) when an abnormal current is detected before said second gate electrode (G2) has been turned on; and to supply a turn-off signal to said first gate electrode (G1), wherein said turn-off signal to the first gate electrode (G1) is delayed relative to the turn-off signal to said second gate electrode (G2).

3. A control device (20) according to claim 2, wherein said timer delay means (45) of said second gate control means (51) comprises first (47) and second (48) time constant determination parts.

4. A control device according to any one of the preceding claims, wherein said timer delay means (31) of said first gate control means (21) comprises first (32) and second (33) time constant determination parts.

5. A control device according to claim 4, wherein said first time constant determination part (32; Fig.17) comprises a first resistor means (32a) connected in series to a second resistor means (32b).

6. A control device according to claim 5 wherein means (53a) for supplying a turn-off signal to the first gate electrode (G1) are connected between the first (32a) and second (32b) resistor means.

7. A control device according to claim 4, wherein said second time constant determination part (33; Fig. 20) is a first capacitor (33a) connected in series to a second capacitor (33b).

8. A control device according to claim 7, wherein means (53a) for supplying a turn-off signal to the first gate electrode (G1) are connected between the first capacitor (33a) and the second capacitor (33b).

9. A control device according to any one of the preceding claims further comprising rectification means (67) capable of passing a current only in a direction from said second gate electrode (G2) to said first gate electrode (G1).

10. A double gate semiconductor apparatus comprising:
a double gate semiconductor device (15;16) having a first gate electrode (Gl) for controlling the ON/OFF transition of a transistor operation, and a second gate electrode (G2) for controlling the transition from a thyristor operation to a transistor operation, wherein the double gate semiconductor device (15,16) is transitted to a thyristor operation when a high voltage is applied to the first gate electrode (G1) and the second gate electrode (G2), and the double gate semiconductor device (15;16) is transitted to a transistor operation when a high voltage is applied only to the first gate electrode (G1); and
a control device in accordance with claim 9 wherein said first gate electrode (G1), said second electrode (G2), and said rectification means (67) comprise polycrystalline silicon formed on the surface of said double gate semiconductor device (16).

11. A double gate semiconductor apparatus according to claim 10, wherein
said first gate electrode (G1) is of an n- type.
said second gate electrode (G2) is of a p-type,
said rectification means (67) has a pn junction, the n-type portion of said rectification means (67) is connected to said first gate electrode (G1), and the p-type portion of said rectification means (67) is connected to said second gate electrode (G2).

12. A double gate semiconductor apparatus according to claim 10, wherein said rectification means has a pn junction and the p-type portion of said rectification means (67) is connected to said second gate electrode (G2) with an aluminium deposition wiring.

## Patentansprüche

1. Steuerschaltung (20) zum Steuern einer Halbleitervorrichtung (15; 16) mit zwei Steuereingängen mit einer ersten Gate-Elektrode (G1) zum Steuern des Übergangs vom leitenden in den nichtleitenden Zustand in einem Transistorbetrieb, mit einer zweiten Gate-Elektrode (G2) zum Steuern des Übergangs von einem Thyristorbetrieb in einen Transistorbetrieb, wobei die Halbleitervorrichtung (15, 16) mit zwei Steuereingängen in einen Thyristorbetrieb übergeht, wenn eine hohe Spannung an der ersten Gate-Elektrode (G1) und an der zweiten Gate-Elektrode (G2) anliegt, wobei die Halbleitervorrichtung (15; 16) mit zwei Steuereingängen in einen Transistorbetrieb übergeht, wenn eine hohe Spannung nur an der ersten Gate-Elektrode (G1) anliegt, **gekennzeichnet durch** folgende Mittel:
ein erstes Gate-Steuermittel (21) mit einem Zeitverzögerungsmittel (31), das ein an die erste Gate-Elektrode (G1) angelegtes sperrend schaltendes Signal verzögert;
ein zweites Gate-Steuermittel (51) mit einem Zeitverzögerungsmittel (45), das sowohl leitend schaltende als auch sperrend schaltende Signale an die zweite Gate-Elektrode (G2) verzögert; und mit
einem Feststellmittel (52) zum Feststellen eines Stromflusses von der Kollektorelektrode zur Emitterelektrode der Halbleitervorrichtung (15; 16) mit zwei Steuereingängen, zum Bestimmen des festgestellten Stromes und nach Feststellen eines anomalen Stromes zum Sperren der Ausgangssignale des ersten Gate-Steuermittels (21) und des zweiten Gate-Steuermittels (51).

2. Steuerschaltung (20) nach Anspruch 1, deren Feststellmittel (52) eingerichtet ist, bei festgestelltem anomalen Strom ein verzögertes leitend schaltendes Signal an die zweite Gate-Elektrode (G2) zu unterdrücken, bevor die zweite Gate-Elektrode (G2) leitet; und zum Liefern eines sperrenden Signals an die erste Gate-Elektrode (G1), wobei das leitend schaltende Signal an die erste Gate-Elektrode (G1) bezüglich des sperrend schaltenden Signals an die zweite Gate-Elektrode (G2) verzögert ist.

3. Steuerschaltung (20) nach Anspruch 2, deren Zeitverzögerungsmittel (45) des zweiten Gate-Steuermittels (51) über ein erstes (47) und ein zweites (48) Zeitkonstanten-Bestimmungsteil verfügt.

4. Steuerschaltung nach einem der vorstehenden Ansprüche, deren Zeitverzögerungsmittel (31) des ersten Gate-Steuermittels (21) über ein erstes (32) und ein zweites (33) Zeitkonstanten-Bestimmungsteil verfügt.

5. Steuerschaltung nach Anspruch 4, deren erstes Zeitkonstanten-Bestimmungsteil (32; Fig. 17) ein erstes Widerstandsmittel (32a) enthält, das mit einem zweiten Widerstandsmittel (32b) in Serie geschaltet ist.

6. Steuerschaltung nach Anspruch 5, deren Mittel (53a) zum Liefern eines leitend schaltenden Signals an die erste Gate-Elektrode (G1) mit dem ersten (32a) und dem zweiten (32b) Widerstandsmittel verbunden ist.

7. Steuerschaltung nach Anspruch 4, deren zweites Zeitkonstanten-Bestimmungsteil (33; Fig. 20) ein erster Kondensator (33a) ist, der mit einem zweiten Kondensator (33b) in Serie geschaltet ist.

8. Steuerschaltung nach Anspruch 7, deren Mittel (53a) zum Liefern eines leitend schaltenden Signals an die erste Gate-Elektrode (G1) zwischen den ersten Kondensator (33a) und den zweiten Kondensator (33b) geschaltet ist.

9. Steuerschaltung nach einem der vorstehenden Ansprüche, die des weiteren ein Gleichrichtmittel (67) enthält, das in der Lage ist, einen Strom nur in einer Richtung von der zweiten Gate-Elektrode (G2) zur ersten Gate-Elektrode (G1) durchzulassen.

10. Halbleitereinrichtung mit zwei Steuereingängen, mit:
einer Halbleitervorrichtung (15; 16) mit zwei Steuereingängen mit einer ersten Gate-Elektrode (G1) zum Steuern des Übergangs vom leitenden zum nichtleitenden Zustand eines Transistorbetriebs, und mit einer zweiten Gate-Elektrode (G2) zum Steuern des Übergangs von einem Thyristorbetrieb in einen Transistorbetrieb, wobei die Halbleitervorrichtung (15, 16) mit zwei Eingängen in einen Thyristorbetrieb übergeht, wenn eine hohe Spannung an der ersten Gate-Elektrode (G1) und an der zweiten Gate-Elektrode (G2) anliegt, und wobei die Halbleitervorrichtung (15; 16) mit zwei Eingängen in einen Transistorbetrieb übergeht, wenn eine hohe Spannung nur an der ersten Gate-Elektrode (G1) anliegt; und mit
einer Steuerschaltung gemäß Anspruch 9, deren erste Gate-Elektrode (G1), deren zweite Gate-Elektrode (G2) und deren Gleichrichtmittel (67) aus polykristallinem Silizium besteht, das auf der Oberfläche der Halbleitervorrichtung (16) mit zwei Eingängen gebildet ist.

11. Halbleitereinrichtung mit zwei Steuereingängen nach Anspruch 10, bei der
die erste Gate-Elektrode (G1) vom n-dotierten Typ ist,
die zweite Gate-Elektrode (G2) vom p-dotierten Typ ist,
das Gleichrichtmittel (67) einen pn-Übergang enthält, wobei der n-dotierte Abschnitt des Gleichrichtmittels (67) mit der ersten Gate-Elektrode (G1) verbunden ist und der p-dotierte Abschnitt des Gleichrichtmittels (67) mit der zweiten Gate-Elektrode (G2) verbunden ist.

12. Halbleitereinrichtung mit zwei Steuereingängen nach Anspruch 10, deren Gleichrichtmittel einen pn-Übergang hat und deren p-dotierter Abschnitt des Gleichrichtmittels (67) über eine beschichtete Aluminiumverdrahtung mit der zweiten Gate-Elektrode (G2) verbunden ist.

## Revendications

1. Dispositif de commande (20) destiné à commander un dispositif (15 ; 16) à semi-conducteur à grille double, ayant une première électrode (G1) de grille destinée à commander la transition état passant/état bloqué (ON/OFF) d'un fonctionnement en transistor, et une seconde électrode (G2) de grille destinée à commander la transition d'un fonctionnement en thyristor à un fonctionnement en transistor, dans lequel le dispositif (15, 16) à semi-conducteur à grille double subit une transition vers un fonctionnement en thyristor lorsqu'une tension élevée est appliquée à la première électrode (G1) de grille et à la seconde électrode (G2) de grille, et le dispositif (15 ; 16) à semi-conducteur à grille double subit une transition à un fonctionnement en transistor lorsqu'une tension élevée est appliquée uniquement à la première électrode (G1) de grille, caractérisé par le fait de comprendre :
des premiers moyens (21) de commande de grille ayant des moyens (31) de retard de temporisation destinés à retarder un signal de passage à l'état bloquant en direction de la première électrode (G1) de grille;
des seconds moyens (51) de commande de grille ayant des moyens (45) de retard de temporisation destinés à retarder à la fois des signaux de passage à l'état passant et des signaux de passage à l'état bloquant en direction de la seconde électrode (G2) de grille ; et
des moyens (52) de détection destinés à détecter un courant passant de l'électrode de collecteur à l'électrode d'émetteur du dispositif (15 ; 16) à semi-conducteur à grille double, à déterminer le courant détecté et à passer à l'état bloquant les signaux de sortie des premiers moyens (21) de commande de grille et les seconds moyens (51) de commande de grille lorsqu'un courant anormal est détecté.

2. Dispositif (20) de commande conformément à la revendication 1, dans lequel les moyens (52) de détection sont agencés pour supprimer un signal de passage à l'état bloquant retardé en direction de la seconde électrode (G2) de grille lorsqu'un courant anormal est détecté avant que la seconde électrode (G2) de grille ne soit passée à l'état passant; et pour fournir un signal de passage à l'état bloquant à la première électrode (G1) de grille, dans lequel le signal de passage à l'état bloquant en direction de la première électrode (G1) de grille est retardé par rapport au signal de passage à l'état bloquant en direction de la seconde électrode (G2) de grille.

3. Dispositif (20) de commande suivant la revendication 2, dans lequel les moyens (45) de retard de temporisation des seconds moyens (51) de commande de grille comportent des première (47) et seconde (48) parties de détermination de constante de temps.

4. Dispositif de commande suivant l'une quelconque des revendications précédentes, dans lequel les moyens (31) de retard de temporisation des premiers moyens (21) de commande de grille comportent des première (32) et seconde (33) parties de détermination de constante de temps.

5. Dispositif de commande suivant la revendication 4, dans lequel la première partie (32; figure 17) de détermination de constante de temps comprend des premiers moyens (32a) à résistance reliés en série à des seconds moyens (32b) à résistance.

6. Dispositif de commande suivant la revendication 5, dans lequel les moyens (53a) destinés à fournir un signal de passage à l'état bloquant à la première électrode (G1) de grille sont connectés entre les premier (32a) et second (32b) moyens à résistance.

7. Dispositif de commande suivant la revendication 4, dans lequel la seconde partie (33 ; figure 20) de détermination de constante de temps est un premier condensateur (33a) relié en série à un second condensateur (33b).

8. Dispositif de commande suivant la revendication 7, dans lequel les moyens (53a) destinés à fournir un signal de passage à l'état bloquant à la première électrode (G1) de grille sont connectés entre le premier condensateur (33a) et le second condensateur (33b).

9. Dispositif de commande suivant l'une quelconque des revendications précédentes, comportant en outre des moyens (67) de redressement capables de faire passer un courant seulement dans un sens de la seconde électrode (G2) de grille à la première électrode (G1) de grille.

10. Dispositif à semi-conducteur à grille double comportant :
un dispositif (15 ; 16) à semi-conducteur à grille double, ayant une première électrode (G1) de grille destinée à commander la transition ON/OFF (état passant/état bloquant) d'un fonctionnement en transistor, et une seconde électrode (G2) de grille destinée à commander la transition d'un fonctionnement en thyristor à un fonctionnement en transistor, dans lequel le dispositif (15, 16) à semi-conducteur à grille double subit une transition vers un fonctionnement en thyristor lorsqu'une tension élevée est appliquée à la première électrode (G1) de grille et à la seconde électrode (G2) de grille, et le dispositif (15 ; 16) à semi-conducteur à grille double subit une transition vers un fonctionnement en transistor lorsqu'une tension élevée est appliquée uniquement à la première électrode (G1) de grille ; et
un dispositif de commande conforme à la revendication 9, dans lequel la première électrode (G1) de grille, la seconde électrode (G2) de grille, et les moyens (67) de redressement comportent du silicium polycristallin formé sur la surface du dispositif (16) à semi-conducteur à grille double.

11. Dispositif à semi-conducteur à grille double suivant la revendication 10, dans lequel
la première électrode (G1) de grille est de conductivité de type n,
la seconde électrode (G2) de grille est de conductivité de type p,
les moyens (67) de redressement comportent une jonction pn, la partie de conductivité de type n des moyens (67) de redressement étant reliée à la première électrode (G1) de grille, et la partie de conductivité de type p des moyens (67) de redressement étant reliée à la seconde électrode (G2) de grille.

12. Dispositif à semi-conducteur à grille double suivant la revendication 10, dans lequel les moyens de redressement comportent une jonction pn et la partie de conductivité de type p des moyens (67) de redressement est connectée à la seconde électrode (G2) de grille par un câblage à dépôt d'aluminium.
